(19) **Europäisches Patentamt**
**European Patent Office**
**Office européen des brevets**

(11) **EP 3 723 142 A1**

(12) **EUROPEAN PATENT APPLICATION**

(43) Date of publication:
**14.10.2020 Bulletin 2020/42**

(51) Int Cl.:
***H01L 31/048*** (2014.01)          ***H02S 50/15*** (2014.01)

(21) Application number: **19168899.3**

(22) Date of filing: **12.04.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Borealis AG**
**1220 Vienna (AT)**

(72) Inventor: **HELLSTRÖM, Stefan**
**44486 Stenungsund (SE)**

(74) Representative: **Maiwald Patent- und
Rechtsanwaltsgesellschaft mbH
Elisenhof
Elisenstraße 3
80335 München (DE)**

(54) **PHOTOVOLTAIC MODULE WITH IMPROVED POWER OUTPUT**

(57)     The present invention relates to a photovoltaic module comprising, preferably consisting of, in the given order, a protective front layer element, a front encapsulation layer element, a photovoltaic cell element, a rear encapsulation layer element, and a protective back element, wherein at least one, preferably both, of the front encapsulation element or the rear encapsulation layer element has independently a haze, being the ratio of the diffuse transmittance and the total transmittance, of not more than 20.0%, and the photovoltaic module shows an increase in short-circuit current, $\Delta I_{sc}$, being the difference of short-circuit current of the total photovoltaic module ($I_{sc}$ (total)) and the short-circuit current of the area of the photovoltaic cell ($I_{sc}$ (cell)) of at least 1.0%, when measured in a flash test on a 1-cell photovoltaic module, wherein $I_{sc}$ (total) is determined on the total 1-cell photovoltaic module and $I_{sc}$ (cell) is determined on the 1-cell photovoltaic module, which has been black-masked to reveal the area of 160 mm x 160 mm, which corresponds to the 1-cell photovoltaic module and thereto a 2 mm gap between the solar cell edges and the black mask and the use of a front encapsulation layer element and/or the rear encapsulation layer element having independently a haze, being the ratio of the diffuse transmittance and the total transmittance, of not more than 20.0%, for increasing the power output of a photovoltaic module comprising, preferably consisting of, in the given order, a protective front layer element, a front encapsulation layer element, a photovoltaic cell element, a rear encapsulation layer element, and a protective back element.

EP 3 723 142 A1

## Description

The present invention relates to a photovoltaic module having at least one encapsulation layer element having a haze value of not more than 20.0 %, which shows an improved power output indicated in an increase in short-circuit current $\Delta I_{SC}$, and the use of said encapsulation layer element for increasing the power output of a photovoltaic module.

## Background art

Photovoltaic modules, also known as solar cell modules, are well known in the solar energy technology. Photovoltaic (PV) modules produce electricity from light and are used in various kind of applications as well known in the field. The type of the photovoltaic module can vary. The photovoltaic modules have typically a multilayer structure, i.e. several different layer elements which have different functions. The photovoltaic module can for example contain a front layer element for protection of the photovoltaic cells, a front encapsulation layer element, at least one element of photovoltaic cells together with connectors, a rear encapsulation layer element, a backsheet layer element and e.g. an aluminium frame.

The protective front layer element can be rigid or flexible. A rigid protective front layer element is typically made of glass, whereas a flexible protective front layer element is typically made of polyvinyl fluoride (PVF), ethylene tetrafluoroethylene (ETFE) or polyvinylidene fluoride (PVDF). These materials ensure high transmittance of the protective front layer element.

The front and rear encapsulation layer elements of photovoltaic modules provide adhesion between the photovoltaic cells and the front and backsheet layer elements. They should be stable at elevated temperatures and high UV exposure. It should also be optically transparent and should have a high thermal resistance. With the trend towards thin photovoltaic modules the thickness of the encapsulation layer elements has developed to below 0.5 mm. However, photovoltaic modules comprising a front and/or rear encapsulation layer of more than 0.5 mm, such as 0.6 mm to 2.0 mm show an increased resistance to potential induced degradation (PID). WO 2017/076629 A1 discloses materials suitable for manufacturing encapsulation layers having the required thickness for obtaining improved PID-resistance.

For increasing the power output of the photovoltaic modules it is believed in the art that the front and encapsulation layer elements, especially the front and rear encapsulation layer elements, need a high transmittance so that a high amount of photons can be absorbed by the photovoltaic cells. High transmittance is usually obtained by low crystallinity of the polymers of the front and rear encapsulation layer elements which result in a low haze and thus in a high transmittance. Consequently, low-crystalline ethylene vinylacetate copolymers are typically used for encapsulation layers which show a low haze and a high transmittance.

In the present invention it has surprisingly been found that encapsulation layer elements having a moderate haze of not more than 20.0 % are not detrimental to the photon absorbance of a photovoltaic module. On the contrary, it has surprisingly been found that the power output of a photovoltaic module comprising a front and/or rear encapsulation layer element having a moderate haze of not more than 20.0 % can be increased due to collection of photons incident to the area of the photovoltaic module which does not cover the at least one element of photovoltaic cells.

## Summary of the invention

The present invention relates to a photovoltaic module comprising, preferably consisting of, in the given order, a protective front layer element, a front encapsulation layer element, a photovoltaic cell element, a rear encapsulation layer element, and a protective back element, wherein at least one, preferably both, of the front encapsulation layer element or the rear encapsulation layer element has independently a haze, being the ratio of the diffuse transmittance and the total transmittance given in %, of not more than 20.0%, and the photovoltaic module shows an increase in short-circuit current, $\Delta I_{SC}$, being the difference of short-circuit current of the total photovoltaic module ($I_{SC}$ (total)) and the short-circuit current of the area of the photovoltaic cell ($I_{SC}$ (cell)) of at least 1.0%, when measured in a flash test on a 1-cell photovoltaic module, wherein $I_{SC}$ (total) is determined on the total 1-cell photovoltaic module and $I_{SC}$ (cell) is determined on the 1-cell photovoltaic module, which has been black-masked to reveal the area of 160 mm x 160 mm, which corresponds to the 1-cell photovoltaic module and thereto a 2 mm gap between the solar cell edges and the black mask.

Further, the present invention relates to the use of a front encapsulation layer element and/or the rear encapsulation layer element having independently a haze, being the ratio of the diffuse transmittance and the total transmittance given in %, of not more than 20.0%, for increasing the power output of a photovoltaic module comprising, preferably consisting of, in the given order, a protective front layer element, a front encapsulation layer element, a photovoltaic cell element, a rear encapsulation layer element, and a protective back element.

It has surprisingly been found that the power output of a photovoltaic module can be increased when using a front encapsulation layer element and/or the rear encapsulation layer element having a moderate haze.
This is shown in a flash test in which the short circuit currents ($I_{SC}$) of the total photovoltaic module and of the same photovoltaic module after provided with a black mask which covers the non-cell area of the photovoltaic module is measured. The non-cell area is the area surrounding the photovoltaic cells. By means of covering said non-cell area with a black mask said area is shielded from photons so that only the area of the photovoltaic cells is exposed to the photons and only direct photon absorbance without scattering is measured by the flash test of the photovoltaic module covered with the black mask. In contrast to that the flash test of the total photovoltaic module not only measures the photons which are directly absorbed by the photovoltaic cells but also those which are scattered from the non-cell area towards the photovoltaic cells and are thus indirectly absorbed. In the flash test used in the present invention the black mask reveals an area 160 mm x 160 mm, which corresponds to the 1-cell photovoltaic module and thereto a 2 mm gap between the solar cell edges and the black mask. When comparing the short circuit currents ($I_{sc}$) of the total photovoltaic module and of the black masked photovoltaic module it has surprisingly been found that photovoltaic modules comprising a front encapsulation layer element and/or the rear encapsulation layer element having a moderate haze show a higher increase in short-circuit current, $\Delta I_{sc}$, being the difference of short-circuit current of the total photovoltaic module ($I_{sc}$ (total)) and the short-circuit current of the area of the photovoltaic cell ($I_{sc}$ (cell)) compared to photovoltaic modules comprising a front encapsulation layer element and/or the rear encapsulation layer element having a low haze.

The haze is determined as the ratio of the diffuse transmittance and the total transmittance measured using a photospectrometer equipped with an integrating sphere detector.

**Definitions**

An "element" in connection with the photovoltaic module of the present invention means a self-contained unit of the photovoltaic module. The elements of the photovoltaic module are preferably connected to form the photovoltaic module by lamination.

"Front" in connection with the photovoltaic module of the present invention means the planar side of the photovoltaic module facing towards the solar irradiation.

"Back" in connection with the photovoltaic module of the present invention means the planar side of the photovoltaic module facing away from the solar irradiation.

The "photovoltaic cell element" is the element of the photovoltaic module which converts the energy of light directly into electricity by the photovoltaic effect. Silicon based material, e.g. crystalline silicon, is a non-limiting example of materials used in photovoltaic cell(s). Crystalline silicon material can vary with respect to crystallinity and crystal size, as well known to a skilled person. Alternatively, the photovoltaic cell element can be a substrate layer on one surface of which a further layer or deposit with photovoltaic activity is subjected, for example a glass layer, wherein on one side thereof an ink material with photovoltaic activity is printed, or a substrate layer on one side thereof a material with photovoltaic activity is deposited. For instance, in well-known thin film solutions of photovoltaic cell elements e.g. an ink with photovoltaic activity is printed on one side of a substrate, which is typically a glass substrate.

"Photovoltaic cell(s)" means herein a layer element of photovoltaic cells, as explained above, together with connectors.

The "non-cell area" A($_{non-cell}$) can be calculated by using the following equation (1):

$$(1)\ A(_{non\text{-}cell}) = A_{module} - A_{cell}$$

$A_{module}$ is preferably equal to $A_{glass}$, wherein A is the Area.

"Haze" in connection with the photovoltaic module of the present invention is determined from transmittance measurements as described below in the experimental section and is defined as the ratio of the diffuse transmittance and the total transmittance of the tested encapsulation layer element. The haze value is given in %.

"Short-circuit current, $I_{sc}$," defines the generated current at short-circuit conditions in the flash test. The short-circuit current is highly dependent on the optical properties of the encapsulant. The more photons are passing through the glass and encapsulant and are absorbed by the photovoltaic cell(s), the higher is the short-circuit current. The short-circuit current is less influenced by the temperature. The short-circuit current slightly increases when the temperature is increased. Consequently, the short-circuit current is a very good parameter for evaluating how a specific encapsulant will influence the power output of a photovoltaic module. The short-circuit current is normally denoted $I_{sc}$ but is sometimes seen as $J_{sc}$. $J_{sc}$ the denotes the short-circuit current density, i.e. the short-circuit current per area unit.

"Rigid" in connection with the photovoltaic module of the present invention means that the element is stiff and cannot be bended in a manner as flexible elements, and if bended, then typically the integrity of the element typically breaks easily causing permanent fractures, as is not the case with flexible element. A skilled person can easily differentiate a rigid and flexible layer element.

A polymer of ethylene herein denotes a polymer which comprises a weight majority of ethylene monomer units, i.e. more than 50 wt% of ethylene monomer units.

"Comonomer" herein refers to copolymerisable comonomer units.

A "silane group(s) containing unit" herein refers to a chemical moiety which comprises one or more silyl groups. The "silane group(s) containing unit" can be part of a polymer or chemical compound which is different from the polymer of ethylene (a). The silane group(s) containing polymer or compound is the added to the polymer composition by blending with the polymer of ethylene (a). The "silane group(s) containing unit" can be part of the polymer of ethylene (a). Thereby, the "silane group(s) containing unit" can be a copolymerizable comonomer unit or a unit which can be chemically grafted onto the polymer of ethylene (a).

A "functional group(s) containing unit" herein refers to a substituent or chemical moiety which is responsible for the characteristic chemical reaction of the accordant polymer or compound.

## Figures

Figure 1 illustrates the layer elements (separated) of the photovoltaic module, namely a protective front layer element (1), a front encapsulation layer element (2), a photovoltaic cell element (3), a rear encapsulation layer element (4) and a protective back layer element (5).

Figure 2 shows a 1 cell photovoltaic module as used in the experimental section.

## Detailed description of the invention

Photovoltaic module

The present invention relates to a photovoltaic module comprising, preferably consisting of, in the given order, a protective front layer element, a front encapsulation layer element, a photovoltaic cell element, a rear encapsulation layer element, and a protective back element, wherein at least one, preferably both, of the front encapsulation layer element or the rear encapsulation layer element has independently a haze, being the ratio of the diffuse transmittance and the total transmittance given in %, of not more than 20.0%, and the photovoltaic module shows an increase in short-circuit current, $\Delta I_{sc}$, being the difference of short-circuit current of the total photovoltaic module ($I_{sc}$ (total)) and the short-circuit current of the area of the photovoltaic cell ($I_{sc}$ (cell)) of at least 1.0%, when measured in a flash test on a 1-cell photovoltaic module, wherein $I_{sc}$ (total) is determined on the total 1-cell photovoltaic module and $I_{sc}$ (cell) is determined on the 1-cell photovoltaic module, which has been black-masked to reveal the area of the 1-cell photovoltaic cell.

In one embodiment the front encapsulation layer element has a haze, being the ratio of the diffuse transmittance and the total transmittance given in %, of not more than 20.0%, such as in the range of from 1.5 to 18% or from 1.5% to 15.0%, preferably in the range of from 2.5% to 12.5%, more preferably in the range of from 3.5% to 11.0%, and most preferably in the range of from 4.0% to 9.5%.

In another embodiment the rear encapsulation layer element has a haze, being the ratio of the diffuse transmittance and the total transmittance given in %, of not more than 20.0%, such as in the range of from 1.5 to 18.0% or from 1.5% to 15.0%, preferably in the range of from 2.5% to 12.5%, more preferably in the range of from 3.5% to 11.0%, and most preferably in the range of from 4.0% to 9.5%.

For bifacial cell it is preferable that the rear and the front encapsulation layer element have a different haze.

In the preferred embodiment both the front encapsulation layer element and the rear encapsulation layer element independently have a haze, being the ratio of the diffuse transmittance and the total transmittance given in %, of not more than 20.0%, such as in the range of from 1.5 to 18% or of from 1.5% to 15.0%, preferably in the range of from 2.5% to 12.5%, more preferably in the range of from 3.5% to 11.0%, and most preferably in the range of from 4.0% to 9.5%.

The photovoltaic module of the invention shows an increase in short-circuit current, $\Delta I_{sc}$, being the difference of short-circuit current of the total photovoltaic module ($I_{sc}$ (total)) and the short-circuit current of the area of the photovoltaic cell ($I_{sc}$ (cell)) of at least 1.0%, such as in the range of from 1.0% to 5.0%, preferably from 1.1% to 4.0%, more preferably from 1.2% to 3.5%, and most preferably from 1.3% to 2.5%.

Thereby, the short-circuit currents are measured in a flash test on a 1-cell photovoltaic module, whereby $I_{sc}$ (total) is determined on the total 1-cell photovoltaic module and $I_{sc}$ (cell) is determined on the 1-cell photovoltaic module, which has been black-masked to reveal the area of 160 mm x 160 mm, which corresponds to the 1-cell photovoltaic module and thereto a 2 mm gap between the solar cell edges and the black mask.

The black-masked area, i.e. the area of the 1-cell photovoltaic module which has been covered by the black mask, is preferably in the range of from 30 to 40% of the total area of the 1-cell photovoltaic module.

The dimensions of the photovoltaic module and the photovoltaic cell used in the flash test are given in the experimental section below.

It is further preferred that the photovoltaic module of the invention shows an increase in short-circuit current,

$\Delta I_{sc}$, being the difference of short-circuit current of the total photovoltaic module ($I_{sc}$ (total)) and the short-circuit current of the area of the photovoltaic cell ($I_{sc}$ (cell)) of at least 0.25%, such as in the range of from 0.25% to 1.25%, preferably from 0.27% to 1.0%, more preferably from 0.30% to 0.88%, and most preferably from 0.32% to 0.63%, when measured in a flash test on a photovoltaic module having multiple cells.

Thereby, the short-circuit currents are measured in a flash test on a photovoltaic module having multiple cells, such as a 60-cell photovoltaic module or a 72-cell photovoltaic module, whereby $I_{sc}$ (total) is determined on the total photovoltaic module having multiple cells and $I_{sc}$ (cell) is determined on the photovoltaic module having multiple cells, which has been black-masked to reveal the area of the photovoltaic module having multiple cells

The black-masked area, i.e. the area of the photovoltaic module having multiple cells which has been covered by the black mask, is preferably in the range of from 5 to 15% of the total area of the photovoltaic module having multiple cells.

The increase in short-circuit current of the photovoltaic module is typically directly proportional to the black-masked area.

As known in the art, the elements and the layer structure of the photovoltaic module of the invention can vary depending on the desired type of the module. The photovoltaic module can be flexible or rigid. In a preferred embodiment the photovoltaic module is a rigid photovoltaic module.

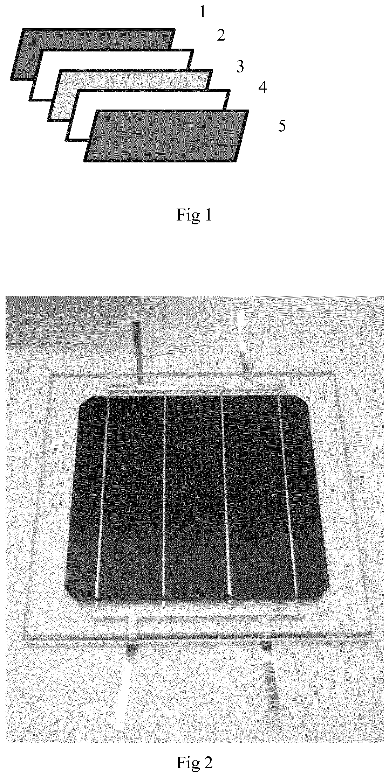

Figure 1 illustrates the general structure of the photovoltaic module of the invention.

The photovoltaic module comprises, preferably consists of, in the given order, a protective front layer element, a front encapsulation layer element, a photovoltaic cell element, a rear encapsulation layer element, and a protective back element. Depending on the nature of the protective back element, the protective back element can optionally be covered by a protective cover, like a metal frame, such as an aluminium frame, which can further comprise a junction box being often mounted on the back glass layer of the element. Such a protective cover is typically only present, when the protective back element is a backsheet layer element or for glass-glass modules.

The protective front layer element can be a rigid element or a flexible element.

The flexible front layer element can be any polymeric material suitable as front layer element, such as e.g. polyvinyl fluoride (PVF), ethylene tetrafluoroethylene (ETFE) or polyvinylidene fluoride (PVDF).

It is, however, preferred that the protective front layer element is a rigid element.
The rigid protective front layer element can be a rigid monolayer element or rigid multilayer element. The rigid monolayer element is preferably a glass layer element. The rigid multilayer element can be e.g. a glass layer element covered from either one or both sides by a polymeric layer(s), like protective polymeric layer(s).

The rigid protective front layer element preferably consists of a glass monolayer element or a multilayer element comprising a glass layer, preferably a glass monolayer element.

The type and thickness of the glass layer element for front protective layer element can vary, depending on the desired PV module solution. Typically the type and thickness of the front glass layer element is as conventionally used in the PV field.

The protective back element can be a rigid element or a flexible element.

The flexible back element typically is a backsheet layer element. The backsheet layer element can be any polymeric material suitable as backsheet layer element, such as e.g. polyethylenterephthalate, polyvinylidenefluoride, polyvinylfluoride or polypropylene.
The backsheet layer element can be a monolayer element or multilayer element. The rigid monolayer element is preferably a layer element made of the polymeric material as discussed above. The multilayer element can be layer element made of the polymeric material as discussed above covered from either one or both sides by a polymeric layer(s), like protective polymeric layer(s) or adhesive polymeric layer(s).

It is, however, preferred that the protective back element is a rigid element.
The rigid protective back element can be a rigid monolayer element or rigid multilayer element. The rigid monolayer element is preferably a glass layer element. The rigid multilayer element can be e.g. a glass layer element covered from either one or both sides by a polymeric layer(s), like protective polymeric layer(s).

The rigid protective back element preferably consists of a glass monolayer element or a multilayer element comprising a glass layer, preferably a glass monolayer element.

The type and thickness of the glass layer element for the protective back element can vary, depending on the desired PV module solution. Typically the type and thickness of the front glass layer element is as conventionally used in the PV field.

In a preferred embodiment the photovoltaic module of the invention comprises a rigid front protective element and a rigid back element and both the rigid front protective element and a rigid back element are glass layer elements.

The front encapsulation layer element preferably comprises a polymer composition comprising a polymer selected from an ethylene-vinylacetate copolymer (EVA), a polyolefin elastomer (POE) or

- a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); and

- silane group(s) containing units (b).

It is preferred that the front encapsulation layer element preferably comprises a polymer composition comprising

- a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); and

- silane group(s) containing units (b),

wherein the polymer composition does not comprise an ethylene-vinylacetate copolymer, or a polyolefin elastomer.
The rear encapsulation layer element preferably comprises a polymer composition comprising a polymer selected from an ethylene-vinylacetate copolymer (EVA), a polyolefin elastomer (POE) or

- a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); and

- silane group(s) containing units (b).

It is preferred that the rear encapsulation layer element preferably comprises a polymer composition comprising

- a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); and

- silane group(s) containing units (b),

wherein the polymer composition does not comprise an ethylene-vinylacetate copolymer, or a polyolefin elastomer.
In a preferred embodiment the front encapsulation layer element and the rear encapsulation layer element both comprise, preferably consist of the polymer composition as defined above or below. Thereby, the polymer composition of the invention of the front encapsulation layer element and of rear encapsulation layer element can be same or different, preferably are the same.
The front encapsulation layer element and/or rear encapsulation layer element can be independently a monolayer element or a multilayer element. Preferably the front and/or rear encapsulation monolayer element or at least one layer of the front and/or rear encapsulation multilayer element consists of the polymer composition of the invention as defined above or below, in any order. In case of a multilayer front and/or back encapsulation layer element, then independently, the at least one layer which comprises, preferably consists of, the polymer composition of the invention is preferably (an) outer layer(s) of the multilayer structure.

More preferably, at least one, preferably both, of the front and back encapsulation layer element is/are an encapsulation monolayer element.

In some embodiments there can be an adhesive layer between the different layer elements and/or between the layers of a multilayer element, as well known in the art. Such adhesive layers have the function to improve the adhesion between the two elements and have a well-known meaning in the lamination field. The adhesive layers are differentiated from the other functional layer elements of the PV module, e.g. those as specified above, below or in claims, as evident for a skilled person in the art.

The protective front layer element, preferably a front glass layer element, a front encapsulation layer element, a photovoltaic element, a rear encapsulation layer element and the protective front layer element, i.e. backsheet layer element, or preferably a back glass layer element, can be produced in a manner well known in the photovoltaic field or are commercially available.

The thickness of the different layer elements of photovoltaic module can vary depending on the type of the photovoltaic module and the material of the layer elements.

As a non-limiting example only, the front and/or back encapsulation layer element, independently typically have a thickness of up to 2.0 mm, preferably up to 1.0 mm, typically from 0.3 mm to 2.0 mm. In certain embodiments thin encapsulation layer elements are used which have a thickness of 0.2 mm to 0.5 mm. In other embodiments thicker encapsulation layer elements are used which have a thickness of more than 0.5 mm to 2.0 mm, preferably from 0.6 to 1.0 mm.

As a non-limiting example only, the thickness of the protective front layer element, e.g. glass layer, is typically up to 10 mm, preferably up to 8 mm, preferably 2 to 4 mm.

As a non-limiting example only, the thickness of the protective back element, e.g. glass layer, is typically up to 10 mm, preferably up to 8 mm, preferably 2 to 4 mm.

As a non-limiting example only, the thickness of a photovoltaic cell element, e.g. an element of monocrystalline photovoltaic cell(s), is typically between 100 to 500 microns.

It is also to be understood that part of the elements can be in integrated form, i.e. two or more of said photovoltaic elements can be integrated together, preferably by lamination, before the integrated elements are assembled for the production of the photovoltaic module.

The photovoltaic module of the invention can be produced in a manner well known in the field of the photovoltaic modules. The polymeric layer elements can be produced for example by extrusion, preferably by co- or cast film extrusion, in a conventional manner using the conventional extruder and film formation equipment. The layers of any multilayer element(s) and/or any adjacent layer(s) between two layer elements can be partly or fully coextruded or laminated.

The different elements of the photovoltaic module are typically assembled together by conventional means to produce the final photovoltaic module. Elements can be provided to such assembly step separately or e.g. two elements can fully or partly be in integrated form, as well known in the art. The different element parts can then be attached together by lamination using the conventional lamination techniques in the field. The assembling of photovoltaic module is well known in the field of photovoltaic modules.

Said front and/or rear encapsulation monolayer element is/are preferably extruded or laminated, preferably laminated, to adjacent layer elements or coextruded with a layer(s) of an adjacent layer element.

The photovoltaic module can be produced in any kind of production process suitable for producing photovoltaic modules.

When producing a rigid photovoltaic module it is preferred that the rigid photovoltaic module of the invention is produced in a lamination process comprising the following steps in the given order:

(i) an assembling step to arrange the rigid protective front layer element, the front encapsulation layer element, the photovoltaic cell element, the rear encapsulation layer element and the rigid protective back element, in given order, to form of a photovoltaic module assembly;
(ii) a heating step to heat up the photovoltaic module assembly optionally in a chamber at evacuating conditions;
(iii) a pressing step to build and keep pressure on the photovoltaic module assembly at the heated conditions for the lamination of the assembly to occur; and
(iv) a recovering step to cool and remove the obtained photovoltaic module for later use.

The lamination process is carried out in a laminator equipment which can be e.g. any conventional laminator which is suitable for the multi-laminate to be laminated. The choice of the laminator is within the skills of a skilled person.

Typically the laminator comprises a chamber wherein the heating, optional, and preferable, evacuation, pressing and recovering (including cooling) steps (ii)-(iv) take place.

The duration of the heating step (ii) is preferably up to 10 minutes, preferably 3 to 7 minutes. The heating step (ii) can be and is typically done step-wise.

It is preferred that the pressing step (iii) is started when at least one of the front encapsulation or rear encapsulation layer element(s) reaches a temperature which is at least 3 to 10°C higher than the melting temperature of the polymer present in said front and/or encapsulation layer element.

The total duration of the pressing step (iii) is preferably up to 15 minutes.

During the pressing step (iii), the duration of the pressure build up is preferably up to 5 minutes, preferably 0.5 to 3 minutes. The pressure built up to the desired level during pressing step can be done either in one step or can be done in multiple steps.

During the pressing step (iii), the duration of holding the pressure is preferably up to 10 minutes, preferably 3.0 to 10 minutes.

The total duration of the pressing step (iii) is preferably from 2 to 10 minutes.

The total duration of the heating step (ii) and pressing step (iii) is preferably up to 25 minutes, preferably from 2 to 20 minutes.

The pressure used in the pressing step (iii) is preferably up to 1000 mbar, preferably 300 to 900 mbar, more preferably 400 to 800 mbar.

Polymer composition of the front and/or rear encapsulation layer element

The front and/or rear encapsulation layer element preferably comprises a polymer composition comprising a polymer selected from an ethylene-vinylacetate copolymer (EVA), a polyolefin elastomer (POE) or

- a polymer of ethylene (a) selected from

   (a1) a copolymer of ethylene which bears functional groups containing units;
   (a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
   (a3) a copolymer of ethylene comprising one or more alpha-olefin comonomer unit(s); and optionally bears functional groups containing units different from said polar comonomer unit(s) of polymer (a2); and

- silane group(s) containing units (b).

It is preferred that the front and/or rear encapsulation layer element consists of the polymer composition as defined above or below.

The ethylene-vinylacetate copolymer (EVA) can be any ethylene-vinylacetate copolymer (EVA) which shows a haze value in the claimed range.

The polyolefin elastomer (POE) can be any polyolefin elastomer (POE) which shows a haze value in the claimed range.

It is preferred that the front and/or rear encapsulation layer element preferably comprises a polymer composition comprising

- a polymer of ethylene (a) selected from

   (a1) a copolymer of ethylene which bears functional groups containing units;
   (a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
   (a3) a copolymer of ethylene comprising one or more alpha-olefin comonomer unit(s); and optionally bears functional groups containing units different from said polar comonomer unit(s) of polymer (a2); and

- silane group(s) containing units (b),

wherein the polymer composition does not comprise an ethylene-vinylacetate copolymer or a polyolefin elastomer.

It is preferred that the polymer composition of the front and/or rear encapsulation layer element comprises, preferably consists of,

- a polymer of ethylene (a) as defined above or below;
- silane group(s) containing units (b) as defined above or below; and
- additive(s) and optionally filler(s), preferably additive(s), as defined below.

Preferably, the comonomer(s) of polymer (a), if present, is/are other than glycidyl methacrylate comonomer. Preferably, the polymer composition is without (does not comprise) a copolymer of ethylene with acrylate and glycidyl methacrylate comonomers.

The alpha-olefin comonomer(s) of polymer of ethylene (a3) are preferably selected from alpha olefins having from 3 to 12 carbon atoms, more preferably from alpha olefins having from 4 to 8 carbon atoms, such as 1-butene, 1-hexene or 1-octene.

The content of alpha-olefin comonomer(s) of polymer of ethylene (a3), is preferably of 4.5 to 18 mol%, preferably of 5.0 to 18.0 mol%, preferably of 6.0 to 18.0 mol%, preferably of 6.0 to 16.5 mol%, more preferably of 6.8 to 15.0 mol%, more preferably of 7.0 to 13.5 mol%

The polymer composition more preferably comprises

- polymer (a) which is selected from

    (a1) a polymer of ethylene which optionally contains one or more comonomer(s) other than the polar comonomer of polymer (a2) and which bears functional groups containing units other than said optional comonomer(s); or
    (a2) a polymer of ethylene containing one or more polar comonomer(s) selected from (C1-C6)-alkyl acrylate or (C1-C6)-alkyl (C1-C6)-alkylacrylate comonomer(s), and optionally bears functional group(s) containing units other than said polar comonomer; and

- silane group(s) containing units (b)

wherein the polymer composition does not comprise an ethylene-vinylacetate copolymer or a polyolefin elastomer.

The silane group(s) containing units (b) and the polymer (a) can be present as separate components, i.e. as blend, in the polymer composition of the invention. Alternatively, the silane group(s) containing units (b) can be present as a comonomer of the polymer (a) or as a compound grafted chemically to the polymer (a). In general, copolymerisation and grafting of the silane group(s) containing units to ethylene are well known techniques and well documented in the polymer field and within the skills of a skilled person.

In case of a blend, the silane group(s) containing units (b) component can be a silane group(s) containing polymer or a silane group(s) containing compound. Said silane group(s) containing compound may, at least partly, be reacted chemically with the polymer (a), e.g. grafted to polymer (a), using optionally e.g. a radical forming agent, such as peroxide. Such chemical reaction may take place before or during the lamination process of the invention.

Preferably the silane group(s) containing units (b) are present (bonded) in the polymer (a). More preferably, the polymer (a) bears functional group(s) containing units, whereby said functional group(s) containing units are said silane group(s) containing units (b). In this embodiment the silane group(s) containing units (b) can be copolymerised or grafted to the polymer (a). Accordingly, the silane group(s) containing units (b) as the preferable functional group(s) containing units are preferably present in said polymer (a) in form of comonomer units or in form of grafted compounds.

In more preferable embodiment of the invention, the polymer (a) comprises functional group(s) containing units which are the silane group(s) containing units (b) as comonomer in the polymer (a). The copolymerisation provides more uniform incorporation of the units (b). Moreover, the copolymerisation does not require the use of peroxide which is typically needed for the grafting of said units to polyethylene. It is known that peroxide brings limitations to the choice of MFR of the polymer used as a starting polymer (during grafting the MFR of the polymer decreases since the peroxide not only initiates the grafting but also crosslinks the polymer) for a PV module and the by-products formed from peroxide can deteriorate the quality of the polymer.

The silane group(s) containing comonomer unit or compound as the silane group(s) containing units (b) is suitably a hydrolysable unsaturated silane compound represented by the formula

$$R^1SiR^2_qY_{3-q} \qquad (I)$$

wherein

R1 is an ethylenically unsaturated hydrocarbyl, hydrocarbyloxy or (meth)acryloxy hydrocarbyl group,
each R2 is independently an aliphatic saturated hydrocarbyl group,
Y which may be the same or different, is a hydrolysable organic group and
q is 0, 1 or 2.

Special examples of the unsaturated silane compound are those wherein R1 is vinyl, allyl, isopropenyl, butenyl, cyclohexanyl or gamma-(meth)acryloxy propyl; Y is methoxy, ethoxy, formyloxy, acetoxy, propionyloxy or an alkyl- or arylamino group; and R2, if present, is a methyl, ethyl, propyl, decyl or phenyl group.

Further suitable silane compounds or, preferably, comonomers are e.g. gamma-(meth)acryloxypropyl trimethoxysilane, gamma(meth)acryloxypropyl triethoxysilane, and vinyl triacetoxysilane, or combinations of two or more thereof.

As a suitable subgroup of unit of formula (I) is an unsaturated silane compound or, preferably, comonomer of formula (II)

$$CH2=CHSi(OA)3 \qquad (II)$$

wherein each A is independently a hydrocarbyl group having 1-8 carbon atoms, suitably 1-4 carbon atoms.

In one embodiment of silane group(s) containing units (b) of the invention, comonomers/compounds of formula (I), preferably of formula (II), are selected from vinyl trimethoxysilane, vinyl bismethoxyethoxysilane, vinyl triethoxysilane, vinyl trimethoxysilane. Mostly preferred is vinyl trimethoxysilane.

The amount of the silane group(s) containing units (b) present in the polymer (a), is from 0.01 to 1.00 mol%, suitably from 0.05 to 0.80 mol%, suitably from 0.10 to 0.60 mol%, suitably from 0.10 to 0.50 mol%, when determined according to "Comonomer contents" as described below under "Determination Methods".

As already mentioned the silane group(s) containing units (b) are preferably present in the polymer (a) as a comonomer.

In one preferable embodiment A1, the polymer composition comprises a polymer (a) which is the polymer of ethylene (a1) which bears the silane group(s) containing units (b) as the functional groups containing units. In this embodiment A1, the polymer of ethylene (a1) preferably does not contain, i.e. is without, a polar comonomer as of polymer (a2) as defined below or an alpha-olefin comonomer.

In said embodiment A1, the polymer of ethylene (a1) preferably contains silane group(s) containing units (b) as comonomer according to formula (I), more preferably silane group(s) containing units (b) as comonomer according to formula (II), more preferably silane group(s) containing units (b) according to formula (II) selected from vinyl trimethoxysilane, vinyl bismethoxyethoxysilane, vinyl triethoxysilane or vinyl trimethoxysilane comonomer. More preferably in this embodiment A1 the polymer of ethylene (a1) is a copolymer of ethylene with a comonomer selected from vinyl trimethoxysilane, vinyl bismethoxyethoxysilane, vinyl triethoxysilane or vinyl trimethoxysilane, most preferably a copolymer of ethylene with vinyl trimethoxysilane comonomer.

In one equally preferable embodiment A2, the polymer composition preferably comprises

- a polymer (a) which is the polymer of ethylene (a2) containing one or more polar comonomer(s) selected from (C1-C6)-alkyl acrylate or (C1-C6)-alkyl (C1-C6)-alkylacrylate, preferably one (C1-C6)-alkyl acrylate, and bears functional group(s) containing units other than said polar comonomer; and
- silane group(s) containing units (b).

More preferably the polymer composition comprises a polymer (a) which is the polymer of ethylene (a2) containing one or more polar comonomer(s) selected from (C1-C6)-alkyl acrylate or (C1-C6)-alkyl (C1-C6)-alkylacrylate comonomer(s), and bears the silane group(s) containing units (b) as the functional group(s) containing units.

The content of the polar comonomer present in the polymer of ethylene (a2) is preferably of 4.5 to 18 mol%, more preferably of 5.0 to 18.0 mol%, still more preferably of 6.0 to 18.0 mol%, even more preferably of 6.0 to 16.5 mol%, even still more preferably of 6.8 to 15.0 mol%, most preferably of 7.0 to 13.5 mol%. The polymer of ethylene (a2) with the polar comonomer and the silane group(s) containing units (b) contains preferably one polar comonomer as defined above or below. In a preferable embodiment of A2, said polar comonomer(s) of copolymer of ethylene (a2) is/are polar comonomer(s) selected from (C1-C3)-alkyl acrylate or (C1-C3)-alkyl methacrylate comonomer(s) or mixtures thereof. More preferably, said polymer of ethylene (a2) contains one polar comonomer which is preferably (C1-C3)-alkyl acrylate comonomer.

The most preferred polar comonomer of polymer of ethylene (a2) is methyl acrylate. The methyl acrylate has very beneficial properties such as excellent wettability, adhesion and optical (e.g. transmittance) properties, which contribute to the quality of the obtained photovoltaic module and e.g. to the lamination process thereof. Moreover, the thermostability properties of methyl acrylate (MA) comonomer are also highly advantageous. For instance, methyl acrylate is the only acrylate which cannot go through the ester pyrolysis reaction, since does not have this reaction path. As a result, if the polymer of ethylene (a2) with MA comonomer degrades at high temperatures, then there is no harmful acid (acrylic acid) formation which improves the quality and life cycle of the PV module. This is not the case e.g. with vinyl acetate of EVA or with other acrylates like ethylene acrylate (EA) or butyl acrylate (BA) which, on the contrary, can go through the ester pyrolysis reaction, and if degrade, would form the harmful acid and for the acrylates also volatile olefinic by-products.

In said embodiment A2, the polymer of ethylene (a2) is a copolymer of ethylene with a (C1-C3)-alkyl acrylate comonomer and silane group(s) containing units (b) according to formula (I) as comonomer, more preferably and silane group(s) containing units (b) according to formula (II) as comonomer, more preferably and silane group(s) containing units (b) according to formula (II) selected from vinyl trimethoxysilane, vinyl bismethoxyethoxysilane, vinyl triethoxysilane or vinyl trimethoxysilane comonomer. More preferably in this embodiment A2 the polymer of ethylene (a2) is a terpolymer of ethylene with methyl acrylate comonomer and with a comonomer selected from vinyl trimethoxysilane, vinyl bismethoxyethoxysilane, vinyl triethoxysilane or vinyl trimethoxysilane. Most preferably the polymer of ethylene (a2) is a terpolymer of ethylene with methyl acrylate comonomer and with vinyl trimethoxysilane comonomer.

The polymer (a) of the polymer composition can be e.g. commercially available or can be prepared according to or analogously to known polymerization processes described in the chemical literature.

In a preferable embodiment the polymer (a), preferably the polymer (a1) or (a2), is produced by polymerising ethylene suitably with silane group(s) containing comonomer (= silane group(s) containing units (b)) as defined above and optionally with one or more other comonomer(s) in a high pressure (HP) process using free radical polymerization in the presence of one or more initiator(s) and optionally using a chain transfer agent (CTA) to control the MFR of the polymer. The HP reactor can be e.g. a well known tubular or autoclave reactor or a mixture thereof, suitably a tubular reactor. The high pressure (HP) polymerisation and the adjustment of process conditions for further tailoring the other properties of the polymer depending on the desired end application are well known and described in the literature, and can readily be used by a skilled person. Suitable polymerisation temperatures range up to 400 °C, suitably from 80 to 350 °C and pressure from 70 MPa, suitably 100 to 400 MPa, suitably from 100 to 350 MPa. The high pressure polymerization is generally performed at pressures of 100 to 400 MPa and at temperatures of 80 to 350 °C. Such processes are well known and well documented in the literature and will be further described later below.

The incorporation of the comonomer(s), if present, and optionally, and preferably, the silane group(s) containing units (b) suitably as comonomer as well as comonomer(s) and the control of the comonomer feed to obtain the desired final content of said comonomers and of optional, and preferable, silane group(s) containing units (b) as the comonomer can be carried out in a well known manner and is within the skills of a skilled person.

Further details of the production of ethylene (co)polymers by high pressure radical polymerization can be found i.a. in the Encyclopedia of Polymer Science and Engineering, Vol. 6 (1986), pp 383-410 and Encyclopedia of Materials: Science and Technology, 2001 Elsevier Science Ltd.: "Polyethylene: High-pressure, R.Klimesch, D.Littmann and F.-O. Mähling pp. 7181-7184.

Such HP polymerisation results in a so called low density polymer of ethylene (LDPE), herein with the optional (polar) comonomer as defined above or in claims and with optional, and preferable silane group(s) containing comonomer as the silane group(s) containing units (b). The term LDPE has a well known meaning in the polymer field and describes the nature of polyethylene produced in HP, i.e the typical features, such as different branching architecture, to distinguish the LDPE from PE produced in the presence of an olefin polymerisation catalyst (also known as a coordination catalyst). Although the term LDPE is an abbreviation for low density polyethylene, the term is understood not to limit the density range, but covers the LDPE-like HP polyethylenes with low, medium and higher densities.

The combination of polymer of ethylene (a1) or polymer of ethylene (a2) as defined above or below with silane group(s) containing units (b) further contributes to the benefit that the polymer of ethylene (a) does not need to be crosslinked, if desired, due to feasible flowability/processability properties thereof. Moreover, said combination does not form any significant volatiles during lamination process. Any decomposition products thereof could be formed only at a temperature close to 400 °C. Therefore, the quality of the obtained laminate is highly desirable, since any premature crosslinking, presence and removal of by-products, which are formed during the crosslinking reaction and may cause bubble formation, can be avoided, if desired. As a result also production of photovoltaic module e.g. by lamination, for example the holding time under pressure during lamination, can be shortened significantly.

The polymer composition of at least one of the front or rear encapsulation layer element is preferably not subjected to any peroxide or silanol condensation catalyst (SCC), which is selected from the group of carboxylates of tin, zinc, iron, lead or cobalt or aromatic organic sulphonic acids, before or during the production process of the photovoltaic module of the invention.

It is to be understood that the peroxide or SCC as defined above are those conventionally supplied for the purpose of crosslinking.

The polymer composition which is crosslinked for instance using the above crosslinking agents has a typical network, i.a. interpolymer crosslinks (bridges), as well known in the field. The crosslinking degree may vary depending on the end application.

In one embodiment no peroxide or silane condensation catalyst (SCC) which is selected from the SCC group of tin-organic catalysts or aromatic organic sulphonic acids is subjected to the polymer composition of said at least one of front or rear encapsulation layer element before or during the production process of the photovoltaic module of the invention.

The silanol condensation catalyst (SCC), which is preferably not used for crosslinking the polymer composition of at least one of the front or rear encapsulation layer element before or during the production process, e.g. by lamination, is more preferably selected from the group C of carboxylates of metals, such as tin, zinc, iron, lead and cobalt; from a titanium compound bearing a group hydrolysable to a Bronsted acid (preferably as described in WO 2011160964 of Borealis, included herein as reference), from organic bases; from inorganic acids; and from organic acids; suitably from carboxylates of metals, such as tin, zinc, iron, lead and cobalt, from titanium compound bearing a group hydrolysable to a Bronsted acid as defined above or from organic acids, suitably from dibutyl tin dilaurate (DBTL), dioctyl tin dilaurate (DOTL), particularly DOTL; titanium compound bearing a group hydrolysable to a Bronsted acid as defined above; or an aromatic organic sulphonic acid, which is suitably an organic sulphonic acid which comprises the structural element:

$$Ar(SO3H)x \qquad (III)$$

wherein Ar is an aryl group which may be substituted or non- substituted, and if substituted, then suitably with at least one hydrocarbyl group up to 50 carbon atoms, and x is at least 1; or a precursor of the sulphonic acid of formula (III) including an acid anhydride thereof or a sulphonic acid of formula (III) that has been provided with a hydrolysable protective group(s), e.g. an acetyl group that is removable by hydrolysis. Such organic sulphonic acids are described e.g. in EP736065, or alternatively, in EP1309631 and EP1309632.

More preferably, the polymer (a) is not crosslinked before introducing to the lamination process or during the lamination process using peroxide, silanol condensation catalyst (SCC), which is selected from the group of carboxylates of tin, zinc, iron, lead or cobalt or aromatic organic sulphonic acids, preferably from the above preferable SCC according to group C, or electronic beam irradiation.

More preferably, also the layer element(s), which is/are in direct contact with the front and/or rear encapsulation layer element(s) comprising the polymer composition as defined above or below, are without a crosslinking agent selected from peroxide or silanol condensation catalyst (SCC), which is selected from the group of carboxylates of tin, zinc, iron, lead or cobalt or aromatic organic sulphonic acids, preferably from the above preferable SCC according to group C.

It is preferred that the polymer composition of at least one, preferably both, of the front or rear encapsulation layer element is not crosslinked with the crosslinking agent, as defined above, before introducing to or during the production process of the PV module or before or during the use of the PV module in the end application.

The polymer of ethylene (a) preferably has a melt flow rate $MFR_2$ (2.16 kg; 190°C) of less than 20 g/10 min, preferably from 0.1 to 15 g/10 min, more preferably from 0.2 to 13 g/10 min, still more preferably from 0.3 to 13, most preferably from 0.4 to 13 g/10 min.

The density of the polymer of ethylene (a) preferably is higher than 860 kg/m$^3$. Preferably the density is not higher than 970 kg/m$^3$, and more preferably is from 920 to 960 kg/m$^3$, according to ISO 1872-2.

The polymer of ethylene (a) preferably has a Shear thinning index, $SHI_{0.05/300}$, of 30.0 to 100.0, preferably of 40.0 to 80.0, when measured according to "Rheological properties: Dynamic Shear Measurements (frequency sweep measurements)" as described below under "Determination Methods".

The preferable SHI range further contributes to the quality of the final PV module and to the short production, e.g. by lamination, cycle time. The preferable SHI also further reduces the stress on the photovoltaic cell element.

In one preferred embodiment, the polymer composition consists of the polymer of ethylene (a) and the silane group(s) containing units (b) as defined above or below.

In another preferred embodiment the polymer composition comprises additives other than fillers (like flame retardants (FRs)). The total amount of said additives is suitably between 0.0001 and 10 wt%, preferably 0.0001 and 5.0 wt%, more preferably 0.0001 and 2.5 wt%.

The polymer composition typically comprises, preferably consists of, based on the total amount (100 wt%) of the polymer composition,

- 90 to 99.9999 wt%, preferably 95.0 to 99.9999 wt%, more preferably 97.5 to 99.9999 wt% of the polymer (a)
- 0.01 to 1.00 mol%, preferably from 0.05 to 0.80 mol%, more preferably from 0.10 to 0.50 mol% silane group(s) containing units (b) and
- 0.0001 to 10 wt%, preferably 0.0001 and 5.0 wt%, more preferably 0.0001 and 2.5 wt% of the additives.

The optional additives are e.g. conventional additives suitable for the desired end application and within the skills of a skilled person, including without limiting to, preferably at least antioxidant(s) and UV light stabilizer(s), and may also include metal deactivator(s), nucleating agent(s), clarifier(s), optical brightener(s), acid scavenger(s), as well as slip agent(s) or talc etc. Each additive can be used e.g. in conventional amounts, the total amount of additives present in the polymer composition being preferably as defined above. Such additives are generally commercially available and are described, for example, in "Plastic Additives Handbook", 5th edition, 2001 of Hans Zweifel.

Especially preferred additives are stabilizers selected from hindered amine light stabiliers (HALS). Especially preferred are Bis(2,2,6,6-tetramethyl-4-piperidyl)sebacat (commercially available from BASF SE as Tinuvin 770, Cas.-No. 52829-07-9), of Poly[[6-[(1,1,3,3-tetramethylbutyl)amino]-1,3,5-triazine-2,4-diyl][(2,2,6,6-tetramethyl-4-piperidinyl)imino]-1,6-hexanediyl[(2,2,6,6-tetramethyl-4-piperidinyl)imino]]) (commercially available from BASF SE as Chimassorb 944, Cas.-No. 71878-19-8) and Butanedioic acid, dimethylester, polymer with 4-hydroxy-2,2,6,6-tetramethyl-1-piperidine ethanol (commercially available from BASF SE as Tinuvin 622, Cas.-No. 65447-77-0).

In another embodiment the polymer composition of the invention comprises in addition to the suitable additives as defined above also fillers, such as pigments, FRs with flame retarding amounts or carbon black. Then the polymer composition of the invention comprises, preferably consists of, based on the total amount (100 wt%) of the polymeric layer element,

- 30 to 90 wt%, preferably 40 to 70 wt%, of the polymer (a)
- 0.01 to 1.00 mol%, preferably from 0.05 to 0.80 mol% silane group(s) containing units (b);
- up to 70 wt%, preferably 30 to 60 wt%, of the filler(s) and
- 0.0001 to 10 wt%, preferably 0.0001 and 5.0 wt% additives.

As non-limiting examples, the optional filler(s) comprise Flame Retardants, such as magnesium hydroxide, ammonium polyphosphate etc.

Preferably, the polymer composition consists of the polymer (a) as the only polymeric component(s). "Polymeric component(s)" exclude herein any carrier polymer(s) of optional additive or filler product(s), e.g. master batch(es) of additive(s) or, respectively, filler(s) together with the carrier polymer, optionally present in the polymer composition of the polymeric layer. Such optional carrier polymer(s) are calculated to the amount of the respective additive or, respectively, filler based on the amount (100 %) of the polymer composition.

It is preferred that the polymer composition has at least one, preferably all of the following properties, determined by DSC:

The polymer composition preferably has a melting peak in the DSC, Tm, of from 70°C to 100°C, more preferably of 80°C to 97°C, most preferably 87°C to 95°C.

The polymer composition preferably has a crystallization temperature $T_c$ of from 50°C to 90°C, more preferably from 60°C to 85°C, and most preferably 70°C to 80°C.

The polymer composition preferably has a crystallization enthalpy $\Delta H_{cryst}$ of from 55 J/g to 90 J/g, more preferably of from 57 J/g to 80 J/g, most preferably of from 60 J/g to 77 J/g, measured from DSC.

The polymer composition preferably has a fusion enthalpy in the DSC $\Delta H_{fusion}$ of from 85 to 110 J/g, more preferably of from 90 J/g to 105 J/g, most preferably of from 95 J/g to 100 J/g.

The polymer composition preferably has a melt flow rate $MFR_2$ (2.16 kg; 190°C) of less than 20 g/10 min, preferably from 0.1 to 15 g/10 min, more preferably from 0.2 to 13 g/10 min, still more preferably from 0.3 to 13, most preferably from 0.4 to 13 g/10 min.

The polymer composition comprising the polymer (a) and the silane group(s) containing units (b), more preferably the polymer of ethylene (a1) or (a2), thus enables to decrease the MFR of the polymer (a), preferably polymer of ethylene (a1) or (a2), compared to prior art and thus offers higher resistance to flow during pressing step (iii) and/or (iv) recovering step of the lamination process. As a result, the preferable MFR can further contribute, if desired, to the quality of the final photovoltaic module of the invention, and to the short production cycle time of the photovoltaic module.

Furthermore, the preferable combination of the preferable low MFR of the polymer composition and the preferable SHI of the polymer (a) further contributes to a desirable high zero shear rate viscosity of the polymer composition, thereby further contributes to the reduction or prevention of the flow out of the material during the production process of the photovoltaic module. And in this preferable embodiment the melt of said polymer (a) further contributes to a proper wetting of various interfaces (layer elements) within the photovoltaic module. Accordingly, the combination of the preferable MFR range of the polymer composition and the preferable SHI of the polymer (a) further contributes to the quality of the final photovoltaic module and to the short production cycle time.

Use

The present invention further relates to the use of a front encapsulation layer element and/or the rear encapsulation layer element having independently a haze, being the ratio of the diffuse transmittance and the total transmittance given in %, of not more than 20.0%, for increasing the power output of a photovoltaic module comprising, preferably consisting of, in the given order, a protective front layer element, a front encapsulation layer element, a photovoltaic cell element, a rear encapsulation layer element, and a protective back element.

The front encapsulation layer element and/or the rear encapsulation layer element preferably has a haze, being the ratio of the diffuse transmittance and the total transmittance given in %, in the range of from 1.5 to 18% or of from 1.5% to 15.0%, preferably in the range of from 2.5% to 12.5%, more preferably in the range of from 3.5% to 11.0%, and most preferably in the range of from 4.0% to 9.5%.

The front encapsulation layer element and the rear encapsulation layer element as well as the photovoltaic module preferably are defined as above or below.

**Examples**

**1. Measurement methods**

**a) Melt flow rate**

The melt flow rate (MFR) is determined according to ISO 1133 - Determination of the melt mass-flow rate (MFR) and melt volume-flow rate (MVR) of thermoplastics -- Part 1: Standard method and is indicated in g/10 min. The MFR is an indication of the flowability, and hence the processability, of the polymer. The higher the melt flow rate, the lower the viscosity of the polymer. The $MFR_2$ of polyethylene is determined at a temperature of 190°C and a load of 2.16 kg.

**b) Density**

Low density polyethylene (LDPE):
The density of the polymer was measured according to ISO 1183-2. The sample preparation was executed according to ISO 1872-2 Table 3 Q (compression moulding).

**c) Comonomer contents**

**The content (wt% and mol%) of polar comonomer present in the polymer and the content (wt% and mol%) of silane group(s) containing units (preferably comonomer) present in the polymer composition (preferably in the polymer):**

Quantitative nuclear-magnetic resonance (NMR) spectroscopy was used to quantify the comonomer content of the polymer composition or polymer as given above or below in the context.
Quantitative $^1$H NMR spectra recorded in the solution-state using a Bruker Advance III 400 NMR spectrometer operating at 400.15 MHz. All spectra were recorded using a standard broad-band inverse 5 mm probehead at 100°C using nitrogen gas for all pneumatics.
Approximately 200 mg of material was dissolved in 1,2-tetrachloroethane-$d_2$ (TCE-$d_2$) using ditertiarybutylhydroxytoluen (BHT) (CAS 128-37-0) as stabiliser. Standard single-pulse excitation was employed utilising a 30 degree pulse, a relaxation delay of 3 s and no sample rotation. A total of 16 transients were acquired per spectra using 2 dummy scans.
A total of 32k data points were collected per FID with a dwell time of 60 $\mu$s, which corresponded to to a spectral window of approx. 20 ppm. The FID was then zero filled to 64k data points and an exponential window function applied with 0.3 Hz line-broadening. This setup was chosen primarily for the ability to resolve the quantitative signals resulting from methylacrylate and vinyltrimethylsiloxane copolymerisation when present in the same polymer.
Quantitative $^1$H NMR spectra were processed, integrated and quantitative properties determined using custom spectral analysis automation programs. All chemical shifts were internally referenced to the residual protonated solvent signal at 5.95 ppm.
When present characteristic signals resulting from the incorporation of vinylacytate (VA), methyl acrylate (MA), butyl acrylate (BA) and vinyltrimethylsiloxane (VTMS), in various comonomer sequences, were observed (Randell89). All comonomer contents calculated with respect to all other monomers present in the polymer.

The vinylacytate (VA) incorporation was quantified using the integral of the signal at 4.84 ppm assigned to the *VA sites, accounting for the number of reporting nuclie per comonomer and correcting for the overlap of the OH protons from BHT when present:

$$VA = (\ I_{*VA} - (I_{ArBHT})/2)\ /\ 1$$

The methylacrylate (MA) incorporation was quantified using the integral of the signal at 3.65 ppm assigned to the IMA sites, accounting for the number of reporting nuclie per comonomer:

$$MA = I_{IMA}\ /\ 3$$

The butylacrylate (BA) incorporation was quantified using the integral of the signal at 4.08 ppm assigned to the 4BA sites, accounting for the number of reporting nuclie per comonomer: BA = $I_{4BA}$ / 2

The vinyltrimethylsiloxane incorporation was quantified using the integral of the signal at 3.56 ppm assigned to the 1VTMS sites, accounting for the number of reporting nuclei per comonomer:

$$VTMS = I_{1VTMS} / 9$$

Characteristic signals resulting from the additional use of BHT as stabiliser, were observed. The BHT content was quantified using the integral of the signal at 6.93 ppm assigned to the ArBHT sites, accounting for the number of reporting nuclei per molecule:

$$BHT = I_{ArBHT} / 2$$

The ethylene comonomer content was quantified using the integral of the bulk aliphatic (bulk) signal between 0.00 - 3.00 ppm. This integral may include the 1VA (3) and $\alpha$VA (2) sites from isolated vinylacetate incorporation, *MA and $\alpha$MA sites from isolated methylacrylate incorporation, 1BA (3), 2BA (2), 3BA (2), *BA (1) and $\alpha$BA (2) sites from isolated butylacrylate incorporation, the *VTMS and $\alpha$VTMS sites from isolated vinylsilane incorporation and the aliphatic sites from BHT as well as the sites from polyethylene sequences. The total ethylene comonomer content was calculated based on the bulk integral and compensating for the observed comonomer sequences and BHT:

$$E = (1/4)*[ I_{bulk} - 5*VA - 3*MA - 10*BA - 3*VTMS - 21*BHT ]$$

It should be noted that half of the $\alpha$ signals in the bulk signal represent ethylene and not comonomer and that an insignificant error is introduced due to the inability to compensate for the two saturated chain ends (S) without associated branch sites.

The total mole fractions of a given monomer (M) in the polymer was calculated as:

$$fM = M / ( E + VA + MA + BA + VTMS )$$

The total comonomer incorporation of a given monomer (M) in mole percent was calculated from the mole fractions in the standard manner:

$$M [mol\%] = 100 * fM$$

The total comonomer incorporation of a given monomer (M) in weight percent was calculated from the mole fractions and molecular weight of the monomer (MW) in the standard manner:

$$M [wt\%] = 100 * ( fM * MW) / ( (fVA * 86.09) + (fMA * 86.09) + (fBA * 128.17) + (fVTMS * 148.23) + ((1-fVA-fMA-fBA-fVTMS) * 28.05) )$$

randall89: J. Randall, Macromol. Sci., Rev. Macromol. Chem. Phys. 1989, C29, 201.

If characteristic signals from other specific chemical species are observed the logic of quantification and/or compensation can be extended in a similar manor to that used for the specifically described chemical species. That is, identification of characteristic signals, quantification by integration of a specific signal or signals, scaling for the number of reported nuclei and compensation in the bulk integral and related calculations. Although this process is specific to the specific chemical species in question the approach is based on the basic principles of quantitative NMR spectroscopy of polymers and thus can be implemented by a person skilled in the art as needed.

**d) Melting temperature (Tm), crystallization temperature ($T_c$), heat of fusion ($\Delta H_{fusion}$), crystallization enthalpy ($\Delta H_{cryst}$) and degree of crystallinity**

Tm, $T_c$, $\Delta H_{fusion}$ and $\Delta H_{cryst}$ were measured with a TA Instrument Q200 differential scanning calorimetry (DSC) on 5 to 7 mg samples. DSC is run according to ISO 11357 / part 3 /method C2 in a heat / cool / heat cycle with a scan rate of 10 °C/min in the temperature range of -30 to +225°C. Crystallization temperature ($T_c$) and crystallization enthalpy ($H_{cryst}$) are determined from the cooling step, while melting temperature ($T_m$) and heat of fusion ($H_{fusion}$) are determined from the second heating step. The crystallinity is calculated from the heat of fusion by assuming an $H_{fusion}$-value of 209 J/g for a fully crystalline polypropylene (see Brandrup, J., Immergut, E. H., Eds. Polymer Handbook, 3rd ed. Wiley, New York, 1989; Chapter 3).

**e) Rheological properties:**

**Dynamic Shear Measurements (frequency sweep measurements)**

The characterisation of melt of polymer composition or polymer as given above or below in the context by dynamic shear measurements complies with ISO standards 6721-1 and 6721-10. The measurements were performed on an Anton Paar MCR501 stress controlled rotational rheometer, equipped with a 25 mm parallel plate geometry. Measurements were undertaken on compression moulded plates, using nitrogen atmosphere and setting a strain within the linear viscoelastic regime. The oscillatory shear tests were done at 190 °C applying a frequency range between 0.01 and 600 rad/s and setting a gap of 1.3 mm.

In a dynamic shear experiment the probe is subjected to a homogeneous deformation at a sinusoidal varying shear strain or shear stress (strain and stress controlled mode, respectively). On a controlled strain experiment, the probe is subjected to a sinusoidal strain that can be expressed by

$$\gamma(t) = \gamma_0 \sin(\omega t) \qquad (1)$$

If the applied strain is within the linear viscoelastic regime, the resulting sinusoidal stress response can be given by

$$\sigma(t) = \sigma_0 \sin(\omega t + \delta) \qquad (2)$$

where

$\sigma_0$ and $\gamma_0$ are the stress and strain amplitudes, respectively
$\omega$ is the angular frequency
$\delta$ is the phase shift (loss angle between applied strain and stress response)
t is the time

Dynamic test results are typically expressed by means of several different rheological functions, namely the shear storage modulus G', the shear loss modulus, G", the complex shear modulus, G*, the complex shear viscosity, $\eta$*, the dynamic shear viscosity, $\eta$', the out-of-phase component of the complex shear viscosity $\eta$" and the loss tangent, tan $\delta$ which can be expressed as follows:

$$G' = \frac{\sigma_0}{\gamma_0} \cos\delta \ [\text{Pa}] \qquad (3)$$

$$G'' = \frac{\sigma_0}{\gamma_0} \sin\delta \ [\text{Pa}] \qquad (4)$$

$$G^* = G' + iG'' \ [\text{Pa}] \qquad (5)$$

$$\eta^* = \eta' - i\eta'' \ [\text{Pa.s}] \qquad (6)$$

$$\eta' = \frac{G''}{\omega} \ [\text{Pa.s}] \qquad (7)$$

$$\eta'' = \frac{G'}{\omega} \ [\text{Pa.s}] \qquad\qquad (8)$$

Besides the above mentioned rheological functions one can also determine other rheological parameters such as the so-called elasticity index *EI(x)*. The elasticity index *EI(x)* is the value of the storage modulus, G' determined for a value of the loss modulus, G" of x kPa and can be described by equation (9).

$$EI(x) = G' \ for \ (G'' = x \ kPa) \ [\text{Pa}] \qquad\qquad (9)$$

For example, the EI(5kPa) is the defined by the value of the storage modulus G', determined for a value of G" equal to 5 kPa.

Shear Thinning Index ($SHI_{0.05/300}$) is defined as a ratio of two viscosities measured at frequencies 0.05 rad/s and 300 rad/s, $\mu_{0.05}/\mu_{300}$.

References:

[1] Rheological characterization of polyethylene fractions" Heino, E.L., Lehtinen, A., Tanner J., Seppälä, J., Neste Oy, Porvoo, Finland, Theor. Appl. Rheol., Proc. Int. Congr. Rheol, 11th (1992), 1,360-362

[2] The influence of molecular structure on some rheological properties of polyethylene", Heino, E.L., Borealis Polymers Oy, Porvoo, Finland, Annual Transactions of the Nordic Rheology Society, 1995.).

[3] Definition of terms relating to the non-ultimate mechanical properties of polymers, Pure & Appl. Chem., Vol. 70, No. 3, pp. 701-754, 1998.

**f) Transmittance and Haze**

Results on transmittance and haze were obtained performing optical measurements on laminated glass/encapsulant/glass samples using one of the polymers described below as encapsulant. The glasses used had a size of 75 mm * 25 mm with a thickness of 1.0 mm. One layer of encapsulant having a thickness of 0.45 mm was sandwiched between glass and lamination of the samples was performed using a P.Energy L036LAB vacuum laminator. Lamination settings used were 150 seconds evacuation at 0 mbar and 150 seconds holding time at a pressure of 100 mbar. After lamination, the total thickness of the laminates was measured with a calliper to ensure that the lamination thickness was greater than 2.35 mm.

After 48h, optical measurements were performed using a Perkin Elmer Lambda 900 UV/VIS/NIR spectrophotometer equipped with a 150 mm integrating sphere. Both the total transmittance and diffuse transmittance were recorded using a 1 nm interval, and the haze as function of wavelength from 400 to 750 nm was calculated by using below equation.

$$Haze \ (\lambda) = \frac{Diffuse \ transmittance \ (\lambda)}{Total \ transmittance \ (\lambda)} * 100$$

**g) Flash test**

Current-voltage (IV) characteristics of the 1-cell glass-glass modules were obtained using a HALM cetisPV-Celltest3 flash tester. Prior to the measurements, the system was calibrated using a reference cell with known IV response. The 1-cell modules were flashed using a 30 ms light pulse from a xenon source. All results from the IV-measurements were automatically converted to standard test conditions (STC) at 25°C by the software PV Control, available from HALM. Every sample setup was flashed three times and given IV parameters are calculated average values of these three individual measurements. All modules were separately flash tested with and without a black mask. The black mask was made out of standard black coloured paper and had a square-shaped opening of 160*160 mm. During flash test, the black mask was positioned in such way that the solar cell in the solar module was totally exposed to the flash pulse, and that there was 2mm gap between the solar cell edges and the black mask. The black mask was fixated to the modules by using tape.

**2. Experimental part**

**a) Preparation of Polymer 1:**

**Copolymer of ethylene with methyl acrylate comonomer and with vinyl trimethoxysilane comonomer**

The copolymer of ethylene with methyl acrylate comonomer and vinyl trimethoxysilane comonomer (polymer 1) was produced in a commercial high pressure tubular reactor at a pressure 2500-3000 bar and max temperature 250-300 °C using conventional peroxide initiatior. Ethylene monomer, methyl acrylate (MA) polar comonomer and vinyl trimethoxy silane (VTMS) comonomer were added to the reactor system in a conventional manner. Chain transfer agent was used to regulate melt flow rate as well known for a skilled person. After having the information of the property balance desired for the final polymer 1, the skilled person can control the process to obtain polymer 1.
The amount of the vinyl trimethoxy silane units, VTMS, the amount of methyl acrylate, MA, and $MFR_2$ are given in the Table 1.
The properties in Table 1 were measured from the polymer 1 as obtained from the reactor.

Table 1: Product properties of polymer 1

| Test polymer | Polymer 1 |
|---|---|
| Properties of the polymer obtained from the reactor | |
| $MFR_{2,16}$, g/10 min | 4.5 |
| Methyl acrylate content, mol% (wt%) | 8.6 (22) |
| Melt Temperature, °C | 90 |
| VTMS content, mol% (wt%) | 0.38 (1.7) |
| Density, kg/m$^3$ | 946 |
| SHI (0.05/300), 150°C | 52 |

In above table 1 and below MA denotes the content of Methyl Acrylate comonomer present in the polymer and, respectively, VTMS content denotes the content of vinyl trimethoxy silane comonomer present in the polymer.

**b) Polymers 2 and 3**

As polymer 2 an ethylene vinylacetate (EVA) copolymer with a vinylacetate (VA) content of 28.9 wt% was used. The polymer further contained 0.4 wt-% of gamma-methacryloxypropyl trimethoxysilane and 0.8 wt-% of a peroxide with a start of decomposition temperature of 137°C.
As polymer 3 an ethylene-1-butylacrylate with a butyl acrylate content of 21.8 wt% was used. The polymer further contained 0.4 wt-% of gamma-methacryloxypropyl trimethoxysilane and 0.8 wt-% of a peroxide with a start of decomposition temperature of 140°C.

**c) Preparation of the polymer compositions for the encapsulation layers of photovoltaic modules 1-5**

For the encapsulation layers of photovoltaic modules 1 only polymer 1 was used. The encapsulation layer for modules 4 and 5 contained polymers 2 and 3 including peroxide and free silane (as described above).
For the encapsulation layers of photovoltaic module 2 polymer 1 was blended with Bis(2,2,6,6-tetramethyl-4-piperidyl)sebacat (commercially available from BASF SE as Tinuvin 770, Cas.-No. 52829-07-9) and Poly[[6-[(1,1,3,3-tetramethylbutyl)amino]-1,3,5-triazine-2,4-diyl][(2,2,6,6-tetramethyl-4-piperidinyl)imino]-1,6-hexanediyl[(2,2,6,6-tetramethyl-4-piperidinyl)imino]]) (commercially available from BASF SE as Chimassorb 944, Cas.-No. 71878-19-8). These stabilizers are also commercially available from other suppliers under different tradenames. They can be equally used. Tinuvin 770 and Chimassorb 944 were added in form of a masterbatch. The resulting blend has an amount of Tinuvin 770 of 1250 ppm and of Chimassorb 944 of 320 ppm.
For the encapsulation layers of photovoltaic module 3 polymer 1 was blended with Butanedioic acid, dimethylester, polymer with 4-hydroxy-2,2,6,6-tetramethyl-1-piperidine ethanol (commercially available from BASF SE as Tinuvin 622, Cas.-No. 65447-77-0). This stabilizer is also commercially available from other suppliers under different tradenames. They can be equally used. Tinuvin 662 was added in form of a masterbatch. The resulting blend has an amount of Tinuvin 662 of 1570 ppm.

**d) Determination of DSC properties of the polymer compositions for the encapsulation layers of photovoltaic modules 1-5**

The polymer compositions as described above were used for determining Tm as described above. The results are shown in Table 2.

Table 2: DSC properties of the polymer compositions

|  | Polymer 1 | Polymer 1 +Tin770+ Chim944 | Polymer 1 + Tin622 | Polymer 2 | Polymer 3 |
|---|---|---|---|---|---|
| Tm, °C | 91 | 91 | 92 | 74 | 88 |

The polymer compositions comprising polymer 1 have a higher Tm as the polymer composition comprising the ethylene vinylacetate of polymer 2. The polymer composition comprising the ethylene butylacrylate copolymer of polymer 3 has DSC properties, which are comparable to those of the polymer compositions comprising polymer 1.

**e) Lamination of the test layer elements for the determination of the haze**

**Front and back layer elements:** as described under section 1f) above

**Encapsulation layer element:** each encapsulation layer element consisted of polymers 1, 2 and 3 as well as the blend of polymer 1 with Tinuvin 770 (Tin 770) + Chimassorb 944 (Chim 944), and the blend of polymer 1 with Tinuvin 622 (Tin 622);
The encapsulation layer elements of the inventive and comparative examples, with dimensions of 995 mm width and 0.45 mm thickness were prepared in a Breyer CellProtect film line, using a melt temperature of 150°C and at lines speeds of 20 mpm (meter per minute). (Adapted for polymer 3).
The encapsulation layer elements were laminated between the front and back layer elements and the total and diffuse transmittance was measured as described above. The haze of the encapsulation layer elements was calculated from the total and diffuse transmittance according to the above described formula.

Table 3: Haze of encapsulation layer elements

| Encapsulation layer element | Haze 400 nm-750 nm, % |
|---|---|
| Polymer 1 | 5.46 |
| Polymer 1 + Tin 770 + Chim 944 | 5.91 |
| Polymer 1 + Tin 622 | 9.24 |
| Polymer 2 | 1.35 |
| Polymer 3 | 8.65 |

It can be seen that the encapsulation layer of the composition of polymer 1 with the stabilizers Tinuvin 770 and Chimassorb 944 has a comparable haze as the encapsulation layer element of polymer 1. The encapsulation layer of the composition of polymer 1 with the stabilizer Tinuvin 622 has a slightly increased haze compared to the encapsulation layer element of polymer 1.
The ethylene vinylacetate copolymer of polymer 2 shows very low haze value and the ethylene butylacrylate copolymer of polymer 3 shows a comparatively high haze value in the range of the polymer 1 containing Tinuvin 622.

**f) Preparation of the photovoltaic modules**

**PV module elements:**

Protective front layer element: Glass layer, non-structured solar glass, i.e. Solatex solar glass, supplied by AGC, length: 200 mm and width: 200 mm, total thickness of 3.2 mm Front and rear encapsulant element: films of the polymer compositions as described above, with same width and length dimensions as the protective front and back layer element, each had the total thickness of 0.45 mm
PV cell element: 1 soldered monocrystalline solar cell, cell dimension 156*156 mm from Tsec Taiwan, pseudosquare, 4 busbars, total thickness of 200 micron.

Protective back layer element: Glass layer, non-structured solar glass, i.e. Solatex solar glass, supplied by AGC, length: 200 mm and width: 200 mm, total thickness of 3.2 mm

**Preparation of PV module (1-cell solar module) assembly for the lamination:**

Two PV module assembly were prepared for each encapsulation layer element as follows. The front protective glass element (Solatex AGC) was cleaned with isopropanol before putting the first encapsulation layer element film on the solar glass. The solar glass element has the following dimensions: 200 mm x 200 x 3,2 mm (b*1*d). The front encapsulation layer element was cut in the same dimension as the solar glass element. After the front encapsulation layer element was put on the front protective glass element, then the soldered solar cell was put on the front encapsulation layer element. Further the rear encapsulation layer element was put on the obtained PV cell element and the back protective glass element (Solatex AGC) was cleaned with isopropanol before it was put on said rear encapsulation layer element. The obtained PV module assembly was then subjected to a lamination process as described below.

**Lamination process of the solar modules:**

**Laminator:** ICOLAM 25/15, supplied by Meier Vakuumtechnik GmbH.
Each PV module assembly sample was laminated in a Meier ICOLAM 25/15 laminator from Meier Vakuumtechnik GmbH with a laminator temperature setting and pressure setting adapted to the encapsulation layer elements. The lamination settings are given in Table 4.

Table 4: Lamination settings for photovoltaic modules 1-5

|  | Module 1 | Module 2 | Module 3 | Module 4 | Module 5 |
|---|---|---|---|---|---|
| Encapsulation layer elements | Polymer 1 | Polymer 1 +Tin722+ Chim944 | Polymer 1 + Tin622 | Polymer 2 | Polymer 3 |
| Temperature, °C | 155 | 155 | 155 | 165 | 150 |
| Pressure, bar (step (iv) | 0.85 | 0.85 | 0.85 | 0.85 | 0.85 |
| Heating (i), min | 180 | 180 | 180 | 480 | 300 |
| Evacuation (ii), s | 300 | 300 | 300 | 120 | 780 |
| Pressure build-up of pressing step (iii), s | 180 | 180 | 180 | 30 | 120 |
| Pressure holding substep of pressing step (iv), s | 540 | 540 | 540 | 720 | 180 |
| Total time of steps (i) to (iv), s | 1200 | 1200 | 1200 | 1350 | 1380 |

A 1 solar cell photovoltaic module prepared according to the lamination process as described above is shown in Fig 2.

**g) Flash test**

Before subjecting the 1 solar cell photovoltaic modules prepared according to the lamination process as described above to the flash test described under section 1 g) they were stored under ambient conditions under indoor lightning for 1 month to account for the initial light induced degradation of the photovoltaic cells.
After that the non-cell area of the photovoltaic modules was covered with black mask which covers the outer rim of the photovoltaic modules as such that an area of 160 mm x 160 mm, which corresponds to the area of the photovoltaic module together with a 2 mm spacing surrounding the photovoltaic module, directly above the photovoltaic cell was revealed. The black-masked photovoltaic modules were subjected to the flash test as described above.
Afterwards the black mask was removed from the non-cell area of the photovoltaic modules and the unmasked modules were again subjected to the flash test as described above.
The short-circuit current ($I_{sc}$) of the black-masked modules ($I_{sc}$ (cell)) and the unmasked modules ($I_{sc}$ (total)) were determined and the increase in short-circuit current ($\Delta I_{sc}$) was determined from the difference of short-circuit current of the total photovoltaic module ($I_{sc}$ (total)) and the short-circuit current of the area of the photovoltaic cell ($I_{sc}$ (cell)). $I_{sc}$ (cell) thereby also includes the reflection from the 2 mm spacing surrounding the photovoltaic module, which was not masked by the black mask. The results are shown in Table 5 below.

Table 5: Increase of $I_{sc}$ for modules 1 to 5

| | Module 1 (IE) | Module 2 (IE) | Module 3 (IE) | Module 4 (CE) | Module 5 (IE) |
|---|---|---|---|---|---|
| Encapsulation layer elements | Polymer 1 | Polymer 1 +Tin722+ Chim944 | Polymer 1 + Tin622 | Polymer 2 | Polymer 3 |
| $\Delta I_{sc}{}^a$ | 1.46 | 1.42 | 1.32 | 0.70 | 1.60 |
| a): average of 3 measurements on 2 modules. | | | | | |

From Table 5 it can be seen that all photovoltaic modules including a front and rear encapsulation layer element comprising polymer 1 (modules 1-3) show a higher increase in short-circuit current ($\Delta I_{sc}$) compared to module 4 which includes a front and rear encapsulation layer element comprising the ethylene vinylacetate copolymer of polymer 2. Module 5 which includes a front and rear encapsulation layer element comprising the ethylene butylacrylate copolymer of polymer 3 shows a comparable increase in short-circuit current ($\Delta I_{sc}$) as modules 1-3.

This effect can be directly correlated with the haze of the accordant encapsulant layer elements as shown in Table 3. A higher haze value results in a higher increase in short-circuit current ($\Delta I_{sc}$).

This effect can be explained in that in the second flash test of the unmasked modules photons, which are incident to the non-cell area (which was covered in the first flash test of the black-masked modules), were allowed to scatter to and be absorbed by the photovoltaic cells which results in a higher short-circuit current.

The results show that encapsulants having a higher crystallinity, melting temperature and haze (see Tables 2 and 3, facilitate photon scattering from non-cell area.

**Claims**

1. A photovoltaic module comprising, preferably consisting of, in the given order, a protective front layer element, a front encapsulation layer element, a photovoltaic cell element, a rear encapsulation layer element, and a protective back element,
   wherein at least one, preferably both, of the front encapsulation layer element or the rear encapsulation layer element has independently a haze, being the ratio of the diffuse transmittance and the total transmittance given in %, of not more than 20.0%, and
   the photovoltaic module shows an increase in short-circuit current, $\Delta I_{sc}$, being the difference of short-circuit current of the total photovoltaic module ($I_{sc}$ (total)) and the short-circuit current of the area of the photovoltaic cell ($I_{sc}$ (cell)) of at least 1.0%, when measured in a flash test on a 1-cell photovoltaic module, wherein $I_{sc}$ (total) is determined on the total 1-cellphotovoltaic module and $I_{sc}$ (cell) is determined on the 1-cell photovoltaic module, which has been black-masked to reveal the area of 160 mm x 160 mm, which corresponds to the 1-cell photovoltaic module and thereto a 2 mm gap between the solar cell edges and the black mask.

2. The photovoltaic module according to claim 1, wherein at least one, preferably both, of the front encapsulation layer element or the rear encapsulation layer element has independently a haze, being the ratio of the diffuse transmittance and the total transmittance given in %, of 1.5 % to 18.0%, preferably in the range of from 1.5 to 15%, more preferably in the range of from 2.5% to 12.5%, even more preferably in the range of from 3.5% to 11.0%, and most preferably in the range of from 4.0% to 9.5%.

3. The photovoltaic module according to claims 1 or 2, wherein the black-masked area for determining $I_{sc}$ (cell) in the flash test is from 30 to 40 % of the total area of the 1-cell photovoltaic module.

4. The photovoltaic module according to any of the preceding claims, shows an increase in short-circuit current, $\Delta I_{sc}$, being the difference of short-circuit current of the total photovoltaic module ($I_{sc}$ (total)) and the short-circuit current of the area of the photovoltaic cell ($I_{sc}$ (cell)) of at least 0.25%, when measured in a flash test on a photovoltaic module with multiple cells, wherein $I_{sc}$ (total) is determined on the total photovoltaic module with multiple cells and $I_{sc}$ (cell) is determined on the photovoltaic module having multiple cells, which has been black-masked to reveal the area of the photovoltaic module with multiple cells.

5. The photovoltaic module according to claim 4, wherein the black-masked area for determining $I_{sc}$ (cell) in the flash test is from 5 to 15 % of the total area of the photovoltaic module with multiple cells.

6. The photovoltaic module according to any of the preceding claims, wherein the at least one, preferably both of the front encapsulation layer element or the rear encapsulation layer element independently comprises a polymer composition comprising a polymer selected from an ethylene-vinylacetate copolymer, a polyolefin elastomer or

- a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); and

- silane group(s) containing units (b).

7. The photovoltaic module according to claim 6, wherein the at least one, preferably both of the front encapsulation layer element or the rear encapsulation layer element independently comprises a polymer composition comprising

- a polymer of ethylene (a) selected from

(a1) a copolymer of ethylene which bears functional groups containing units;
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears functional groups containing units different from said polar comonomer unit(s);
(a3) a copolymer of ethylene comprising one or more alpha-olefin comonomer unit(s); and optionally bears functional groups containing units different from said polar comonomer unit(s) of polymer (a2); and

- silane group(s) containing units (b),

wherein the polymer composition does not comprise an ethylene-vinylacetate copolymer or a polyolefin elastomer.

8. The photovoltaic module according to any one of the preceding claims, wherein the at least one, preferably both of the front encapsulation layer element or the rear encapsulation layer element independently comprises a polymer composition comprising

(a1) a copolymer of ethylene which bears silane group(s) containing units (b) as functional groups containing units; or
(a2) a copolymer of ethylene comprising one or more polar comonomer unit(s) selected from (C1-C6)-alkyl acrylate or (C1-C6)-alkyl (C1-C6)-alkyl acrylate comonomer units, and optionally bears silane group(s) containing units (b) as functional groups containing units different from said polar comonomer unit(s), preferably a polymer composition comprising
(a1) a copolymer of ethylene which bears silane group(s) containing units (b) as functional groups containing units; or
(a2) a polymer of ethylene comprising methyl acrylate comonomer units and bears silane group(s) containing units (b) as functional groups containing units different from said polar comonomer unit(s),

more preferably a polymer composition comprising a copolymer of ethylene (a1) with vinyl trimethoxysilane comonomer units or a terpolymer of ethylene (a2) with methyl acrylate comonomer units and vinyl trimethoxysilane comonomer units.

9. The photovoltaic module according to any one of the preceding claims, wherein the at least one, preferably both of the front encapsulation layer element or the rear encapsulation layer element independently comprises a polymer composition having at least one, preferably all of the following properties determined by DSC:

- a crystallization temperature $T_c$ of from 50°C to 90°C,

- a crystallization enthalpy $\Delta H_{cryst}$ of from 55 J/g to 90 J/g,
- a melting peak Tm of from 70°C to 100°C,
- a fusion enthalpy $\Delta H_{fusion}$ of from 85 to 110 J/g.

10. The photovoltaic module according to any one of the preceding claims, wherein the at least one, preferably both of the front encapsulation layer element or the rear encapsulation layer element independently comprises a polymer composition having at least one, preferably all of the following properties

- a melt flow rate $MFR_2$ (2.16 kg; 190°C) of less than 20 g/10 min,
- a shear thinning index $SHI_{0.05/300}$ of from 30.0 to 100.0.

11. The photovoltaic module according to any one of the preceding claims, wherein the at least one, preferably both of the front encapsulation layer element or the rear encapsulation layer element independently comprises a polymer composition which is not cross-linked in the presence of a peroxide or a silanol condensation catalyst selected from carboxylates of tin, zinc, iron, lead or cobalt or aromatic organic sulphonic acids.

12. The photovoltaic module according to any one of the preceding claims, wherein the protective front layer element is a rigid protective front layer element, preferably a front glass layer element.

13. The photovoltaic module according to any one of the preceding claims, wherein the protective back layer element is a rigid protective back layer element, preferably a back glass layer element.

14. The photovoltaic module according to any one of claims 1 to 12, wherein the protective back layer element is a polymeric backsheet.

15. The use of a front encapsulation layer element and/or the rear encapsulation layer element having independently a haze, being the ratio of the diffuse transmittance and the total transmittance given in %, of not more than 20.0%, for increasing the power output of a photovoltaic module comprising, preferably consisting of, in the given order, a protective front layer element, a front encapsulation layer element, a photovoltaic cell element, a rear encapsulation layer element, and a protective back element.

1
2
3
4
5

Fig 1

Fig 2

Europäisches
Patentamt

European
Patent Office

Office européen
des brevets

# EUROPEAN SEARCH REPORT

Application Number

EP 19 16 8899

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H11 307791 A (SANYO ELECTRIC CO) 5 November 1999 (1999-11-05) * abstract; figures 4,7 * * figures 1,3,5,6,8,10-12 * * paragraphs [0001], [0011], [0019], [0023], [0028], [0030] - [0032], [0036] * | 1-6,9-15 | INV. H01L31/048 H02S50/15 |
| X | JP 2015 198129 A (JX NIPPON OIL & ENERGY CORP) 9 November 2015 (2015-11-09) * abstract; figures 1,3 * * paragraphs [0001], [0004] - [0013], [0024], [0031] - [0036] * | 1-6,9-15 | |
| X | WO 2018/141672 A1 (BOREALIS AG [AT]) 9 August 2018 (2018-08-09) * abstract; figures 1,2 * * page 1 - page 2 * * page 7 - page 12 * * page 17 * * page 43 - page 49 * * page 58 - page 69; tables 1,2,3,4 * | 1-15 | |
| A | WO 2018/171951 A1 (BOREALIS AG [AT]) 27 September 2018 (2018-09-27) * the whole document * | 1-15 | TECHNICAL FIELDS SEARCHED (IPC) H01L H02S |
| A | PHILIPPE VOARINO ET AL: "Optical Integration Improvements for Bifacial Cells", PROCEEDINGS OF THE 26TH EUROPEAN PHOTOVOLTAIC SOLAR ENERGY CONFERENCE, 5 - 9 SEPTEMBER 2011, 13 October 2011 (2011-10-13), pages 3321-3324, XP040637871, ISBN: 978-3-936338-27-0 * the whole document * | 1,3-5,15 | |

The present search report has been drawn up for all claims

| Place of search | Date of completion of the search | Examiner |
|---|---|---|
| Berlin | 25 October 2019 | Sagol, Bülent Erol |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 19 16 8899

This annex lists the patent family members relating to the patent documents cited in  the above-mentioned European search report.
The members are as contained in the European Patent Office EDP file on
The European Patent Office is in no way liable for these particulars which are merely given for the purpose of information.

25-10-2019

| Patent document cited in search report | | Publication date | Patent family member(s) | | Publication date |
|---|---|---|---|---|---|
| JP H11307791 | A | 05-11-1999 | JP | 3670835 B2 | 13-07-2005 |
| | | | JP | H11307791 A | 05-11-1999 |
| JP 2015198129 | A | 09-11-2015 | NONE | | |
| WO 2018141672 | A1 | 09-08-2018 | AU | 2018216859 A1 | 08-08-2019 |
| | | | CN | 110234502 A | 13-09-2019 |
| | | | TW | 201831324 A | 01-09-2018 |
| | | | WO | 2018141672 A1 | 09-08-2018 |
| WO 2018171951 | A1 | 27-09-2018 | TW | 201834847 A | 01-10-2018 |
| | | | WO | 2018171951 A1 | 27-09-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2017076629 A1
- WO 2011160964 A
- EP 736065 A
- EP 1309631 A
- EP 1309632 A

### Non-patent literature cited in the description

- Encyclopedia of Polymer Science and Engineering. 1986, vol. 6, 383-410
- Polyethylene: High-pressure. **R.KLIMESCH ; D.LITTMANN ; F.-O. MÄHLING.** Encyclopedia of Materials: Science and Technology. Elsevier Science Ltd, 2001, 7181-7184
- **HANS ZWEIFEL.** Plastic Additives Handbook. 2001
- *CHEMICAL ABSTRACTS,* 52829-07-9
- *CHEMICAL ABSTRACTS,* 71878-19-8
- *CHEMICAL ABSTRACTS,* 65447-77-0
- *CHEMICAL ABSTRACTS,* 128-37-0
- **J. RANDALL.** *Macromol. Sci., Rev. Macromol. Chem. Phys.,* 1989, vol. C29, 201
- Polymer Handbook. Wiley, 1989
- **HEINO, E.L. ; LEHTINEN, A. ; TANNER J. ; SEPPÄLÄ, J. ; NESTE OY.** Rheological characterization of polyethylene fractions. *Theor. Appl. Rheol., Proc. Int. Congr. Rheol,* 1992, vol. 1, 360-362
- **HEINO, E.L. ; BOREALIS POLYMERS OY.** The influence of molecular structure on some rheological properties of polyethylene. *Annual Transactions of the Nordic Rheology Society,* 1995
- Definition of terms relating to the non-ultimate mechanical properties of polymers. *Pure & Appl. Chem.,* 1998, vol. 70 (3), 701-754